# EUROPÄISCHE PATENTSCHRIFT

(11) **EP 1 755 170 B1**
(45) Veröffentlichungstag und Bekanntmachung des Hinweises auf die Patenterteilung: **20.04.2011**
(21) Anmeldenummer: 06016916.6
(22) Anmeldetag: 14.08.2006
(51) Int. Cl.: H01L 31/048, H01L 31/05

(54) **Solarzellenverbund und Solareinheit mit diesem Solarzellenverbund**
Solar cell composite and solar unit comprising said solar cell composite
Assemblage de cellules solaire et unité solaire comprenant cet assemblage de cellules solaires

(30) Priorität: 16.08.2005 DE 102005038735
(43) Veröffentlichungstag der Anmeldung: 21.02.2007
(73) Patentinhaber: Webasto AG, 82131 Stockdorf (DE)
(72) Erfinder: Teschner, Helmut, 86899 Landsberg (DE); Kogler, Rupert, 82166 Gräfelfing (DE)
(74) Vertreter: nospat Patent- und Rechtsanwälte Naefe Oberdorfer Schmidt

(56) Entgegenhaltungen:
- EP-A- 1 544 921
- WO-A-99/17379
- DE-C1- 19 527 740

## Beschreibung

Die Erfindung betrifft einen Solarzellenverbund nach dem Oberbegriff des Anspruchs 1 und eine Solareinheit nach dem Oberbegriff des Anspruchs 13.

Einen gattungsgemäßen Solarzellenverbund offenbart die DE 195 27 740 C1. Mehrere Solarzellen sind zwischen Klebefolien gehalten, wobei die Solarzellen und die Klebefolien zwischen einer oberen Glasschicht und einer unteren Deckglasschicht eingebettet sind. Diesen Verbund umgebend ist eine Vergussmasse angeordnet, in welcher ein Deckelinnenblech eingegossen ist.

Aus der EP 1 544 921 A1 ist ein Solarzellenverbund mit eingebetteten Solarzellen bekannt, wobei im Bereich der Rückseite dieses Verbundes eine Verstärkungselement angeordnet sein kann. Das Verstärkungselement ist zur dem Lichteinfall abgekehrten Rückseite der Solarzelle hin in unterschiedlichen Ausführungsformen abgebogen und bildet so einen Montagebereich und einen Führungsbereich für elektrische Drähte, um diese geordnet aus dem Solarzellenbereich nach außen zu führen und eine Anschlussbox zu installieren.

Aus der WO 99/17379 sind verschiedene Arten des Einlaminierens von Solarzellen zwischen schützenden Kunststoffschichten bekannt.

Aus der DE 28 32 475 ist ein Solargenerator bekannt, bei dem ein Solarzellenverbund umschäumt ist, um ein wenig bruchempfindliches Rahmenelement, welches ein geringes Gewicht aufweist, auszubilden.

Aus der DE 101 01 770 A1 sind Solarmodule mit einer Polyurethaneinbettung und ein Verfahren zu deren Herstellung bekannt. Es wird vorgeschlagen, einzelne Solarzellen in einem Polyurethanverbund einzugießen, wobei einseitig die Solarzellen vollflächig in ein opakes Polyurethan eingebettet sind und anderseitig eine transparente Polyurethanschicht aufgetragen wird. Bei einem derartigen Solarmodul ist von Nachteil, dass es ein relativ hohes Gewicht aufweist und zudem ein hoher Materialaufwand an Polyurethan notwendig ist. Weiterhin muss im Herstellungsprozess eine zuverlässige Trennung des opaken Polyurethans vom transparenten Polyurethan sichergestellt werden.

Aus der EP 0325369 A2 ist ein photovoltaisches Modul bekannt, welches in einem umspritzten Kunststoffgehäuse angeordnet ist, wobei das Kunststoffgehäuse die Rückseite des photovoltaischen Moduls vollständig abdeckt und eine dem Lichteinfall zugewandte Vorderseite des photovoltaischen Moduls größtenteils frei lässt, das photovoltaische Modul jedoch randlich umgreift. Zur Aussteifung des Gehäuses wird vorgeschlagen, ggf. Versteifungselemente in den Gehäuserahmen einzugießen. Bei diesem photovoltaischen Modul ist von Nachteil, dass auf der dem Lichteinfall zugewandten Oberseite zwangsläufig Stufen entstehen, wodurch ein ungehindertes Abfließen von Wasser oder das Abrutschen von Schnee behindert ist.

Aufgabe der Erfindung ist es, eine gewichtsoptimierte Solareinheit unter Verwendung eines Solarzellenverbunds anzugeben. Des Weiteren soll die erfindungsgemäße Solareinheit eine verbesserte Befestigung des Solarzellenverbunds innerhalb der Solareinheit zur Verfügung stellen. Außerdem soll die Solareinheit dahingehend optimiert sein, dass auftreffendes Wasser oder Schnee auf einer dem Lichteinfall zugewandten Seite leicht abfließen bzw. abrutschen kann.

Die erfindungsgemäße Solareinheit soll insbesondere zur Bildung eines Solarglasdaches zum Einsatz in Kraftfahrzeugen und zur Bildung von Solardachziegeln zur Anordnung auf einem Gebäudedach geeignet sein.

Diese Aufgabe wird mit einer Solareinheit mit den Merkmalen des Anspruchs 13 und einem Solarzellenverbund mit den Merkmalen des Anspruchs 1 gelöst. Vorteilhafte Ausführungsformen sind in den von den unabhängigen Ansprüchen abhängigen Ansprüchen angegeben.

Im Folgenden wird die Erfindung beispielhaft anhand der Zeichnung erläutert. Es zeigen:
- Figur 1:: einen Randbereich einer erfindungsgemäßen Solarein- heit in einer Querschnittsdarstellung;
- Figur 2:: eine erste Ausführungsform der erfindungsgemäßen So- lareinheit in einer Draufsicht;
- Figur 3:: eine zweite Ausführungsform der erfindungsgemäßen So- lareinheit in einer Draufsicht.

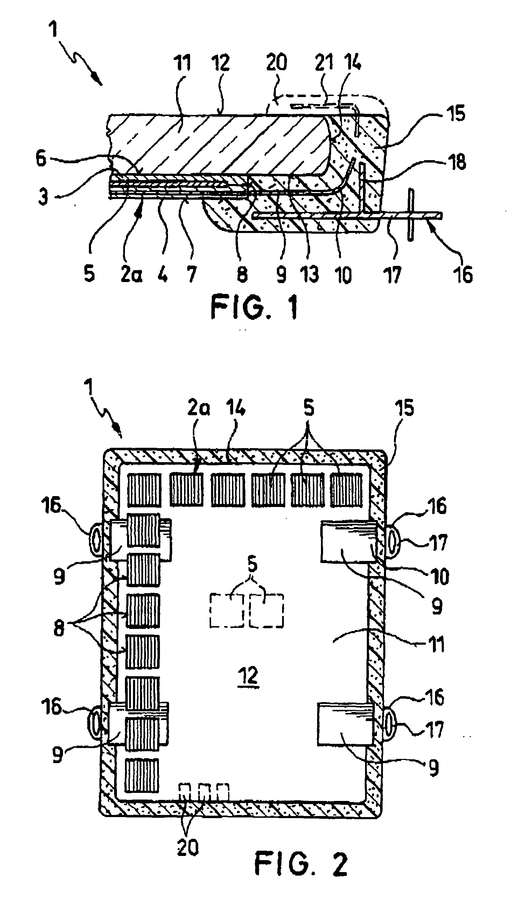

Eine erfindungsgemäße Solareinheit 1 (Figur 1) weist zumindest ein, bevorzugt jedoch eine Vielzahl von Solarzellen 5 auf, die zu einem Solarzellenverbund 2a zusammengefasst sind.

Der erfindungsgemäße Solarzellenverbund 2a weist in üblicher Art und Weise einen Schichtaufbau mit einer transparenten, dem Lichteinfall zugewandten tragenden Schicht 11, einer ebenfalls transparenten Deckschicht 3 und einer opaken- oder einer reflektierenden Basisschicht 4 auf der dem Lichteinfall abgewandten Seite auf. Zwischen der Deckschicht 3 und der Basisschicht 4 ist eine Vielzahl photovoltaisch aktiver Solarzellen 5 angeordnet. Die Deckschicht 3 besitzt eine dem Lichteinfall zugewandte Oberseite 6 und die Basisschicht 4 besitzt eine gegenüberliegende Unterseite 7.

Die tragende Schicht 11 ist z. B. als Deckglasscheibe 11 ausgebildet. Der erfindungsgemäße Solarzellenverbund 2a ist als Schichtlaminat ausgebildet und weist, wie vorbeschrieben, die tragende Schicht 11, die Deckschicht 3, die Basisschicht 4 und die zumindest eine Solarzelle 5 auf. Die Deckschicht 3 und die Basisschicht 4 sind beispielsweise Folienschichten, welche zwischen sich die Solarzellen 5 aufnehmen und in den Zwischenräumen zwischen den Solarzellen 5 sowie im randlichen Außenbereich in der Nähe einer randlichen Begrenzungskante 8 miteinander verklebt oder anderweitig aufeinanderlaminiert, z. B. verschmolzen sind. Selbstverständlich ist es auch möglich, die Deckschicht 3 und die Basisschicht 4 als Kunststoffformteile auszubilden, in denen die Solarzellen 5 eingebettet sind. Die Kunststoffformteile der Deckschicht 3 und der Basisschicht 4 sind in einem solchen Fall in den Bereichen zwischen den Solarzellen 5 randlich umlaufend miteinander verbunden.

Erfindungsgemäß weist der Solarzellenverbund 2a im Laminatverbund zusätzlich zumindest ein Verstärkungselement 9 auf, welches fest und innig mit dem Solarzellenverbund 2a verbunden ist. Die innige Verbindung des Verstärkungselements 9 erfolgt beispielsweise dadurch, dass das Verstärkungselement 9 z. B. in die opake Basisschicht 4, welche beispielsweise aus einem undurchsichtigen Kunststoff ausgebildet ist, eingegossen ist. Alternativ bietet sich an, bei einer Ausgestaltung der Deckschicht 3 und der Basisschicht 4 als Folienelemente, das Verstärkungselement 9 zumindest teilbereichsweise zwischen den Folienelementen oder zwischen der Deckschicht 4 und der tragenden Schicht 11 mit einzulaminieren. Wesentlich ist, dass das zumindest eine Verstärkungselement 9 randlich zumindest teilbereichsweise über die Begrenzungskante 8, einen freien Anbindungsbereich 10 bildend, hinausragt.

Das Verstärkungselement 9 ist z. B. ein flächiges Gewebe, Gewirke oder eine Folie.

Gemäß einer besonders bevorzugten Ausführungsform des Verstärkungselements 9 als starres Material weist das Verstärkungselement 9 über dessen Fläche verteilt eine Vielzahl von Durchbrüchen, z. B. Löcher oder Durchsetzungen auf, deren Vorteile weiter unten näher erläutert werden.

Zur Ausbildung eines erfindungsgemäßen Solarzellenverbunds 2a ist die Deckschicht 3 mit ihrer Oberseite 6 gegen die Deckglasscheibe 11 gesetzt und dort befestigt, z. B. verklebt. Die Deckglasscheibe 11 hat die Aufgabe, die empfindlichen Solarzellen 5 vor der Einwirkung äußerer Einflüsse, z. B. Regen, Schnee, Hagel zu schützen. Die Deckglasscheibe 11 ist für den Einsatz des Solarzellenverbunds 2a in einem Kraftfahrzeug, beispielsweise als Teil eines Glasdachs, Glashubdachs oder Glaslamellendachs ausgebildet.

Die Deckglasscheibe 11 weist eine dem Lichteinfall zugewandte Oberseite 12, eine der Oberseite 12 gegenüberliegende Unterseite 13 und eine randliche Begrenzungskante 14 auf. Die Begrenzungskante 8 ist im Randbereich des Solarzellenverbunds 2a bevorzugt gegenüber der Begrenzungskante 14 der Deckglasscheibe 11 etwas zurückgesetzt angeordnet, wobei jedoch auch eine Anordnung gegenüber der Deckglasscheibe 11 möglich ist, bei der die Begrenzungskante 8 und die Begrenzungskante 14 miteinander fluchten oder die Begrenzungskante 8 sogar ein Stück über die Begrenzungskante 14 hinaus ragt.

Eine erfindungsgemäße Solareinheit 1 besitzt einen Solarzellenverbund 2a und als tragendes Teil einen randlich umlaufenden Rahmen 15. Der Rahmen 15 ist bevorzugt aus einem Polyurethanschaum oder aus einem anderen spritz- und/oder gießbaren Material ausgebildet. Der Rahmen 15 umgibt die Deckglasscheibe 11 im Bereich ihrer Begrenzungskante 14 und schließt in einer besonders bevorzugten Ausführungsform bündig mit der Oberseite 12 der Deckglasscheibe 11 ab. Weiterhin ist die Deckglasscheibe 11 umfänglich lediglich in einem Randbereich, der im Vergleich zur flächenmäßigen Erstreckung der Deckglasscheibe 11 klein ist, vom Rahmen 15 umgeben. Ein randlicher Teilbereich der Schichten 3 und 4 ist in dem Rahmen 15 mit eingebettet. Bei einer derartigen Rahmenumschäumung des Randbereichs des Solarzellenverbunds 2a erfolgt die Anbindung des PU-Schaums des Rahmens 15 an die Deckglasscheibe 11 und and die Basisschicht 4 lediglich über Adhäsion, was den Nachteil hat, dass die Dauerfestigkeit der Verbindung zwischen dem Rahmen 15 und der Deckglasscheibe 11 sowie der Basisschicht 4 im Betrieb nicht immer dauerhaft sichergestellt werden kann. Erfindungsgemäß ist der Nachteil dadurch vermieden, dass das oder die Verstärkungselement(e) 9 mit deren freiem Anbindungsbereich 10 beim Umschäumen bzw. Umspritzen des Solarzellenverbunds 2a mit dem Rahmenmaterial mit in den Rahmen 15 eingegossen bzw. eingeschäumt werden. Hierdurch wird ein wesentlich verbesserter, insbesondere formschlüssig ausgebildeter Halt des Rahmens 15 bezüglich des Solarzellenverbunds 2a erreicht. Dies führt zu einer wesentlich verbesserten Dauerfestigkeit der Anbindung des Rahmens 15.

Besonders vorteilhaft ist hierbei die Ausgestaltung der Verstärkungselemente 9 mit Durchbrüchen oder Durchsetzungen (nicht gezeigt), da hierdurch beim Einschäumen der formschlüssiger Verbund zwischen dem Verstärkungselement 9 und dem Rahmen 15 verbessert ist, was eine besonders gute, haltbare und belastbare Verbindung der Verstärkungselemente 9 im Rahmen 15 zur Folge hat.

Gemäß einer weiteren bevorzugten Ausführungsform sind in den Rahmen 15 zur Befestigung der erfindungsgemäßen Solareinheit 1 beispielsweise an einem Fahrzeugdach oder an einem Gebäudedach Befestigungselemente 16 mit in den Rahmen 15 eingegossen oder eingeschäumt. Für einen guten Halt der Befestigungselemente 16 im Rahmen 15 ist es vorteilhaft, die Befestigungselemente 16 hinsichtlich ihrer Raumform derart auszubilden, dass eine formschlüssige Einbettung im Material des Rahmens 15 erfolgt. Beispielsweise haben die Befestigungselemente 16 eine t-förmige Raumform mit einem ersten Schenkel 17 und einem zweiten Schenkel 18, wobei zumindest ein Teilbereich des ersten Schenkels 17 und der Schenkel 18 im Rahmenmaterial des Rahmens 15 eingebettet sind. Ein freies Ende des ersten Schenkels 17 überragt den Rahmen 15 randlich und dient zur Befestigung der erfindungsgemäßen Solareinheit 1 am Fahrzeugdach oder Gebäudedach.

Gemäß einer weiteren Ausführungsform (nicht gezeigt), ist der Rahmen 15 umfänglich nicht vollständig um die Deckglasscheibe 11 umlaufend ausgebildet sondern lediglich segmentiert, d. h. abschnittsweise im Randbereich des Solarzellenverbunds 2a vorgesehen. In einem einfachsten Fall kann der Rahmen 15 lediglich in den Bereichen der Krafteinleitung über die Befestigungselemente 16 vorgesehen sein und an den üblichen Bereichen des Randes des Solarzellenverbunds 2a weggelassen sein.

Gemäß einer ersten Ausführungsform (Figur 2) der erfindungsgemäßen Solareinheit 1 und/oder des erfindungsgemäßen Solarzellenverbunds 2a ist jeweils ein flächiges Verstärkungselement 9 im Bereich der Befestigungselemente 16 angeordnet, wobei jeweils der freie Anbindungsbereich 10 der Verstärkungselemente 9 im Rahmen 15 eingegossen bzw. eingeschäumt ist und die Verstärkungselemente 9 anderendig ein Stück in den Solarzellenverbund 2a hinein ragen und mit dem Solarzellenverbund 2a, wie oben beschrieben, flächig verbunden sind. Eine derartige Anordnung führt bei einer Krafteinleitung über die Befestigungselemente 16 in die Solareinheit 1 dazu, dass die eingeleitete Kraft flächig verteilt wird und somit eine lokale Überbeanspruchung der Verbindung des Rahmens 15 an der Deckglasscheibe 11 oder dem Solarzellenverbund 2a, was eine Ablösung des Rahmens 15 zur Folge haben könnte, vermieden ist.

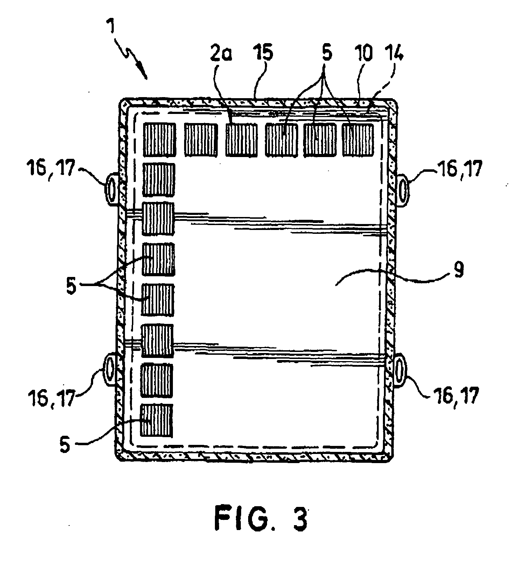

Gemäß einer weiteren Ausführungsform der erfindungsgemäßen Solareinheit 1 (Figur 3) ist die flächige Ausdehnung des Verstärkungselements 9 derart gewählt, dass das Verstärkungselement 9 den Solarzellenverbund 2a vollflächig umfasst und mit einem randlich umlaufenden freien Anbindungsbereich 10 den Verbund etwas überragt, wobei dieser freie Anbindungsbereich 10 randlich umlaufend im Rahmen 15 eingegossen bzw. eingespritzt ist. Eine derartige Ausbildung hat den Vorteil, dass eine weitere flächige Verteilung der eingeleiteten Kräfte stattfindet und zudem ein optisch einheitlicher Eindruck, beispielsweise in der Draufsicht entsteht. Im Übrigen ist die Anbindung des Rahmens 15 an die Deckglasscheibe 11 entlang des gesamten Umfangs der Solareinheit 1 verbessert. Außerdem ist eine verbesserte Verbindung der Deckschicht 3 an der Deckglasscheibe 11 erreicht.

Der Werkstoff der Deckglasscheibe 11 ist nicht auf transparentes Glas beschränkt. Vielmehr eignen sich auch sämtliche transparenten formstabilen Kunststoffe, die die Anforderungen hinsichtlich der Lichtdurchlässigkeit und der Konstanz dieser Lichtdurchlässigkeit über die Zeit erfüllen.

Zur Ausbildung der erfindungsgemäßen Solareinheit 1 als Solardachziegel ist vorteilhafterweise der Rahmen 15 hinsichtlich seiner Außenkontur derart geformt, dass er beispielsweise mit benachbarten Dachplatten kommunizieren kann und somit ein formschlüssiges Einlegen oder Einhängen möglich ist.

Bei der erfindungsgemäßen Solareinheit ist von besonderem Vorteil, dass der Rahmen 15 lediglich im Randbereich der Deckglasscheibe 11 vorgesehen werden kann und die Unterseite des Solarzellenverbunds 2a frei bleiben kann. Dies reduziert das Gewicht und auch den Materialaufwand für die Herstellung.

Gemäß einer weiteren vorteilhaften Ausführungsform (nicht gezeigt), schließt der Rahmen 15 entlang seines randlichen Verlaufs um den Solarzellenverbund 2a lediglich teilbereichsweise bündig mit der Oberseite 12 der Deckglasscheibe 11 ab. Zwischen zwei bündigen Abschlussbereichen kann es zweckmäßig sein, den Rahmen 15, die Deckglasscheibe 11 umgreifend auszubilden. Somit kann der Rahmen 15 auch fingerartige Elemente 20 besitzen, welche die Deckglasscheibe 11 in deren Randbereich bis auf die Oberseite 12 umgreifen. Zwischen zwei benachbarten fingerartigen Elementen 20 (vgl. Figur 2) schließt der Rahmen 15 bündig mit der Oberseite 12 der Deckglasscheibe 11 ab, so dass ein zinnenartiges Randgebilde entsteht, welches ein nahezu ungehindertes Abfließen von Wasser von der Oberseite 12 der Deckglasscheibe 11 gewährleistet.

Zur Versteifung der fingerartigen Elemente 20 können beispielsweise Verstärkungsteile 21, z. B. Metall- oder Kunststoffwinkelelemente, die im Bereich der fingerartigen Elemente 20 in den Rahmen 15 eingegossen sind, vorgesehen sein.

Wegen des zumindest bereichsweise bündigen Übergangs von der Oberseite 12 der Deckglasscheibe 11 zum Rahmen 15 ist ein leichtes Abfließen von z. B. Regenwasser und ein Abrutschen von z. B. Schnee hindernisfrei oder nahezu hindernisfrei möglich, so dass der Lichteinfall auf die Solarzelle 5 optimiert und somit die Leistungsfähigkeit der Solareinheit verbessert ist.

### Bezugszeichenliste:

- 1: Solareinheit
- 2a: Solarzellenverbund
- 3: Deckschicht
- 4: Basisschicht
- 5: Solarzellen
- 6: Oberseite
- 7: Unterseite
- 8: Begrenzungskante
- 9: Verstärkungselement
- 10: freier Anbindungsbereich
- 11: Deckglasschicht, tragende Schicht
- 12: Oberseite
- 13: Unterseite
- 14: Begrenzungskante
- 15: Rahmen
- 16: Befestigungselement
- 17: 1. Schenkel
- 18: 2. Schenkel
- 20: fingerartiges Element
- 21: Verstärkungsteil

## Patentansprüche

1. Solarzellenverbund mit einer tragenden Schicht (11) und zumindest einer Solarzelle (5), die zwischen einer Deckschicht (3) und einer Basisschicht (4) angeordnet ist, wobei der Solarzellenverbund (2a) zumindest ein Verstärkungselement (9) besitzt, welches zumindest teilbereichsweise mit dem Solarzellenverbund (2a) verbunden ist und einen freien Anbindungsbereich (10) zum Verbinden mit einem tragenden Teil einer Solareinheit (1) besitzt, wobei das Verstärkungselement (9) aus einem biegsamen, schmiegsamen Material ausgebildet ist, **dadurch gekennzeichnet, dass** das Verstärkungselement ein flächiges Gewebe, Gewirke oder eine Folie ist.

2. Solarzellenverbund nach Anspruch 1, **dadurch gekennzeichnet, dass** die tragende Schicht (11) eine Deckglasschicht (11) ist.

3. Solarzellenverbund nach Anspruch 1 oder 2, **dadurch gekennzeichnet, dass** der Solarzellenverbund (2a) als Laminat aus der tragenden Schicht (11), der Basisschicht (4), der Deckschicht (3) und den Solarzellen (5) ausgebildet ist, wobei die Basisschicht (4) und die Deckschicht (3) Folien sind.

4. Solarzellenverbund nach einem der vorangegangenen Ansprüche, **dadurch gekennzeichnet, dass** die Deckschicht (3) und die Basisschicht (4) als Formteil ausgebildet sind, welche zumindest eine Solarzelle 5 aufnehmend miteinander verbindbar sind.

5. Solarzellenverbund nach einem der vorhergehenden Ansprüche, **dadurch gekennzeichnet, dass** die Deckschicht (3) und die Basisschicht (4) eine einstückige Umgießung/Umspritzung der zumindest einen Solarzelle (5) ist.

6. Solarzellenverbund nach einem der vorhergehenden Ansprüche, **dadurch gekennzeichnet, dass** das Verstärkungselement (9) zumindest im Bereich seines freien Anbindungsbereichs (10) Durchbrüche, Durchsetzungen oder Aufrauungen der Oberfläche besitzt.

7. Solarzellenverbund nach einem der vorhergehenden Ansprüche, **dadurch gekennzeichnet, dass** das Verstärkungselement (9) eine Teilschicht des Laminats (3, 4, 11) ist.

8. Solarzellenverbund nach einem der vorhergehenden Ansprüche, **dadurch gekennzeichnet, dass** das Verstärkungselement (9) in dem die Solarzelle (5) umgebenden Material eingegossen, eingespritzt ist.

9. Solarzellenverbund nach einem der vorhergehenden Ansprüche, **dadurch gekennzeichnet, dass** das Verstärkungselement (9) mit seinem freien Anbindungsbereich (10) randlich über den Solarzellenverbund (2a) übersteht.

10. Solarzellenverbund nach einem der vorhergehenden Ansprüche, **dadurch gekennzeichnet, dass** das Verstärkungselement (9) teilflächig im Bereich von Krafteinleitungsstellen vorhanden ist.

11. Solarzellenverbund nach einem der vorhergehenden Ansprüche, **dadurch gekennzeichnet, dass** das Verstärkungselement (9) bezüglich des Solarzellenverbunds (2a) vollflächig ausgebildet ist.

12. Solarzellenverbund nach einem der vorhergehenden Ansprüche, **dadurch gekennzeichnet, dass** das Verstärkungselement (9) im Bereich einer freien Oberseite (6) der Deckschicht (3) angeordnet ist, so dass das Verstärkungselement (9) direkt mit einer Deckglasschicht (11) verbindbar ist.

13. Solareinheit mit einem Solarzellenverbund nach einem oder mehreren der Ansprüche 1 bis 12, mit einem Rahmen (15) als tragendes Teil, wobei der freie Anbindungsbereich (10) des Solarzellenverbunds (2a) mit dem Rahmen (15) verbunden ist.

14. Solareinheit nach Anspruch 13, **dadurch gekennzeichnet, dass** der Rahmen (15) aus einem Polyurethanmaterial, insbesondere einem Polyurethanschaum gebildet ist.

15. Solareinheit nach Anspruch 13 oder 14, **dadurch gekennzeichnet, dass** der freie Anbindungsbereich (10) des Verstärkungselements (9) formschlüssig im Rahmen (15) eingegossen oder eingeschäumt ist.

16. Solareinheit nach einem der Ansprüche 13 bis 15, **dadurch gekennzeichnet, dass** der Rahmen (15) zumindest teilweise randlich umlaufend um die Deckglasscheibe (11) angeordnet ist.

17. Solareinheit nach einem der Ansprüche 13 bis 16, **dadurch gekennzeichnet, dass** der Rahmen (15) einen Randbereich der Deckglasscheibe (11) und einen Randbereich der Deckschicht (3) und der Basisschicht (4) sowie den freien Anbindungsbereich (10) der Verstärkungselemente (9) einbettend ausgebildet ist.

18. Solareinheit nach einem der Ansprüche 14 bis 17, **dadurch gekennzeichnet, dass** der Rahmen (15) mit der Oberseite (12) der Deckglasscheibe (11) zumindest bereichsweise bündig abschließt.

19. Solareinheit nach einem der Ansprüche 13 bis 18, **dadurch gekennzeichnet, dass** der Rahmen (15) die Deckglasscheibe (11) zumindest teilbereichsweise umgreifend ausgebildet ist.

20. Solareinheit nach einem oder mehreren der Ansprüche 13 bis 19, **dadurch gekennzeichnet, dass** im Rahmen (15) Befestigungselemente (16) eingebettet sind.

21. Solareinheit nach einem oder mehreren der Ansprüche 13 bis 20, **dadurch gekennzeichnet, dass** die Verstärkungselemente (9) randlich umlaufend im Rahmen eingegossen/eingeschäumt sind.

22. Solareinheit nach einem oder mehreren der Ansprüche 13 bis 21, **dadurch gekennzeichnet, dass** der Rahmen (15) hinsichtlich seiner Raumform zur Anbindung im Bereich eines Kraftfahrzeugdachs oder zur Montage auf einem Gebäudedach ausgebildet ist.

23. Verwendung einer Solareinheit nach einem oder mehreren der Ansprüche 13 bis 22 als Solardachmodul für ein Kraftfahrzeug.

24. Verwendung einer Solareinheit nach einem oder mehreren der Ansprüche 13 bis 22 als Solardachziegel.

## Claims

1. Solar cell composite comprising a supporting layer (11) and at least one solar cell (5), which is arranged between a top layer (3) and a base layer (4), the solar cell composite (2a) having at least one reinforcing element (9), which is connected at least over a partial region to the solar cell composite (2a) and has a free attaching region (10) for connecting to a supporting part of a solar unit (1), the reinforcing element (9) being formed from a flexible, compliant material, **characterized in that** the reinforcing element is a sheet-like woven or knitted fabric or a film.

2. Solar cell composite according to Claim 1, **characterized in that** the supporting layer (11) is a cover glass layer (11).

3. Solar cell composite according to Claim 1 or 2, **characterized in that** the solar cell composite (2a) is formed as a laminate comprising the supporting layer (11), the base layer (4), the top layer (3) and the solar cells (5), where the base layer (4) and the top layer (3) are films.

4. Solar cell composite according to one of the preceding claims, **characterized in that** the top layer (3) and the base layer (4) are each formed as a moulded part, which can be connected to each other so as to accommodate at least one solar cell (5).

5. Solar cell composite according to one of the preceding claims, **characterized in that** the top layer (3) and the base layer (4) constitute a one-piece overmoulding/encapsulation of the at least one solar cell (5).

6. Solar cell composite according to one of the preceding claims, **characterized in that** the reinforcing element (9) has at least in the region of its free attaching region (10) apertures, openings or roughenings in the surface.

7. Solar cell composite according to one of the preceding claims, **characterized in that** the reinforcing element (9) is a sublayer of the laminate (3, 4, 11).

8. Solar cell composite according to one of the preceding claims, **characterized in that** the reinforcing element (9) is moulded or injection-moulded in the material surrounding the solar cell (5).

9. Solar cell composite according to one of the preceding claims, **characterized in that** the reinforcing element (9) peripherally projects with its free attaching region (10) beyond the solar cell composite (2a).

10. Solar cell composite according to one of the preceding claims, **characterized in that** the reinforcing element (9) is present with part of its surface area in the region of points of force introduction.

11. Solar cell composite according to one of the preceding claims, **characterized in that** the reinforcing element (9) is formed over the full surface area with respect to the solar cell composite (2a).

12. Solar cell composite according to one of the preceding claims, **characterized in that** the reinforcing element (9) is arranged in the region of a free upper side (6) of the top layer (3), so that the reinforcing element (9) can be connected directly to a cover glass layer (11).

13. Solar unit comprising a solar cell composite according to one or more of Claims 1 to 12, with a frame (15) as a supporting part, the free attaching region (10) of the solar cell composite (2a) being connected to the frame (15).

14. Solar unit according to Claim 13, **characterized in that** the frame (15) is formed from a polyurethane material, in particular a polyurethane foam.

15. Solar unit according to Claim 13 or 14, **characterized in that** the free attaching region (10) of the reinforcing element (9) is moulded or foamed in the frame (15) in a form-fitting manner.

16. Solar unit according to one of Claims 13 to 15, **characterized in that** the frame (15) is arranged as at least partially peripherally encircling the cover glass plate (11).

17. Solar unit according to one of Claims 13 to 16, **characterized in that** the frame (15) is formed as embedding a peripheral region of the cover glass plate (11) and a peripheral region of the top layer (3) and the base layer (4) as well as the free attaching region (10) of the reinforcing elements (9).

18. Solar unit according to one of Claims 14 to 17, **characterized in that** the frame (15) finishes flush with the upper side (12) of the cover glass plate (11), at least in a certain region or regions.

19. Solar unit according to one of Claims 13 to 18, **characterized in that** the frame (15) is formed as engaging around the cover glass plate (11), at least in a partial region or regions.

20. Solar unit according to one or more of Claims 13 to 19, **characterized in that** fastening elements (16) are embedded in the frame (15).

21. Solar unit according to one or more of Claims 13 to 20, **characterized in that** the reinforcing elements (9) are moulded/foamed in the frame in a peripherally encircling manner.

22. Solar unit according to one or more of Claims 13 to 21, **characterized in that** the frame (15) is spatially formed for attaching in the region of a motor vehicle roof or for mounting on a building roof.

23. Use of a solar unit according to one or more of Claims 13 to 22 as a solar roof module for a motor vehicle.

24. Use of a solar unit according to one or more of Claims 13 to 22 as a solar roof tile.

## Revendications

1. Assemblage de cellules solaires avec une couche porteuse (11) et au moins une cellule solaire (5), qui est disposée entre une couche de recouvrement (3) et une couche de base (4), dans lequel l'assemblage de cellules solaires (2a) comporte au moins un élément de renforcement (9), qui est relié au moins dans une zone partielle à l'assemblage de cellules solaires (2a) et qui possède une zone de liaison libre (10) pour la liaison à une partie porteuse d'une unité solaire (1), dans lequel l'élément de renforcement (9) est réalisé en une matière flexible souple, **caractérisé en ce que** l'élément de renforcement est un tissu ou un tricot plat ou une feuille plate.

2. Assemblage de cellules solaires selon la revendication 1, **caractérisé en ce que** la couche porteuse (11) est une couche de protection en verre (11).

3. Assemblage de cellules solaires selon la revendication 1 ou 2, **caractérisé en ce que** l'assemblage de cellules solaires (2a) est réalisé sous la forme d'un stratifié composé de la couche porteuse (11), de la couche de base (4), de la couche de recouvrement (3) et des cellules solaires (5), dans lequel la couche de base (4) et la couche de recouvrement (3) sont des feuilles.

4. Assemblage de cellules solaires selon l'une quelconque des revendications précédentes, **caractérisé en ce que** la couche de recouvrement (3) et la couche de base (4) sont réalisées sous forme de pièces moulées, qui peuvent être assemblées l'une à l'autre en enfermant au moins une cellule solaire (5).

5. Assemblage de cellules solaires selon l'une quelconque des revendications précédentes, **caractérisé en ce que** la couche de recouvrement (3) et la couche de base (4) forment un enrobage d'une seule pièce formé par coulée ou projection autour de ladite au moins une cellule solaire (5).

6. Assemblage de cellules solaires selon l'une quelconque des revendications précédentes, **caractérisé en ce que** l'élément de renforcement (9) présente des passages, des ouvertures ou des zones rugueuses de la surface au moins dans la région de sa zone de liaison libre (10).

7. Assemblage de cellules solaires selon l'une quelconque des revendications précédentes, **caractérisé en ce que** l'élément de renforcement (9) est une couche partielle du stratifié (3, 4, 11).

8. Assemblage de cellules solaires selon l'une quelconque des revendications précédentes, **caractérisé en ce que** l'élément de renforcement (9) est formé par coulée, ou injection, dans le matériau entourant la cellule solaire (5).

9. Assemblage de cellules solaires selon l'une quelconque des revendications précédentes, **caractérisé en ce que** l'élément de renforcement (9) déborde du côté du bord, par sa zone de liaison libre (10), au-delà de l'assemblage de cellules solaires (2a).

10. Assemblage de cellules solaires selon l'une quelconque des revendications précédentes, **caractérisé en ce que** l'élément de renforcement (9) est présent sur une partie de la surface dans la région de points d'application de force.

11. Assemblage de cellules solaires selon l'une quelconque des revendications précédentes, **caractérisé en ce que** l'élément de renforcement (9) est réalisé sur toute la surface par rapport à l'assemblage de cellules solaires (2a).

12. Assemblage de cellules solaires selon l'une quelconque des revendications précédentes, **caractérisé en ce que** l'élément de renforcement (9) est disposé dans la région d'un côté supérieur libre (6) de la couche de recouvrement (3), de telle manière que l'élément de renforcement (9) puisse être relié directement à une couche de protection en verre (11).

13. Unité solaire avec un assemblage de cellules solaires selon une ou plusieurs des revendications 1 à 12, avec un cadre (15) comme partie porteuse, dans laquelle la zone de liaison libre (10) de l'assemblage de cellules solaires (2a) est reliée au cadre (15).

14. Unité solaire selon la revendication 13, **caractérisée en ce que** le cadre (15) est formé en un matériau de polyuréthane, en particulier en une mousse de polyuréthane.

15. Unité solaire selon la revendication 13 ou 14, **caractérisée en ce que** la zone de liaison libre (10) de l'élément de renforcement (9) est noyée par moulage ou moussage de forme complémentaire dans le cadre (15).

16. Unité solaire selon l'une quelconque des revendications 13 à 15, **caractérisée en ce que** le cadre (15) est disposé au moins partiellement sur le bord en entourant la vitre de protection (11).

17. Unité solaire selon l'une quelconque des revendications 13 à 16, **caractérisée en ce que** le cadre (15) est réalisé de façon à enrober une zone de bord de la vitre de protection (11) et une zone de bord de la couche de recouvrement (3) et de la couche de base (4) ainsi que la zone de liaison libre (10) des éléments de renforcement (9).

18. Unité solaire selon l'une quelconque des revendications 14 à 17, **caractérisée en ce que** le cadre (15) se termine au moins localement à fleur du côté supérieur (12) de la vitre de protection (11).

19. Unité solaire selon l'une quelconque des revendications 13 à 18, **caractérisée en ce que** le cadre (15) est réalisé de façon à encadrer au moins localement la vitre de protection (11).

20. Unité solaire selon une ou plusieurs des revendications 13 à 19, **caractérisée en ce que** des éléments de fixation (16) sont noyés dans le cadre (15).

21. Unité solaire selon une ou plusieurs des revendications 13 à 20, **caractérisée en ce que** les éléments de renforcement (9) sont noyés par moulage ou moussage dans le cadre en périphérie du côté du bord.

22. Unité solaire selon une ou plusieurs des revendications 13 à 21, **caractérisée en ce que** le cadre (15) est réalisé, au niveau de sa forme spatiale, en vue de l'assemblage dans la région d'un toit de véhicule automobile ou du montage sur un toit de bâtiment.

23. Utilisation d'une unité solaire selon une ou plusieurs des revendications 13 à 22, comme module solaire de toit pour un véhicule automobile.

24. Utilisation d'une unité solaire selon une ou plusieurs des revendications 13 à 22 comme tuile solaire.
